# EUROPEAN PATENT SPECIFICATION

(11) **EP 1 436 555 B1**
(45) Date of publication and mention of the grant of the patent: **10.10.2007**
(21) Application number: 02785278.9
(22) Date of filing: 21.10.2002
(51) Int. Cl.: F25B 9/14

(54) **A PULSE TUBE REFRIGERATOR SLEEVE**
BUCHSE FÜR PULSATIONSROHRKÜHLVORRICHTUNG
GAINE POUR REFRIGERATEUR A TUBE PULSE

(30) Priority: 19.10.2001 GB 0125188
(43) Date of publication of application: 14.07.2004
(73) Proprietor: Siemens Magnet Technology Limited, Bracknell, Berks. RG12 8FZ (GB)
(72) Inventor: STAUTNER, Wolfgang, Oxford 0X2 9SN (GB); STEINMEYER, Florian, Herzogenaurach 91074 (DE)
(74) Representative: French, Clive Harry
(86) International application number: PCT/EP2002/011815
(87) International publication number: WO 2003/036207

(56) References cited:
- EP-A- 0 717 245
- EP-A- 0 781 956
- EP-A- 0 905 435
- EP-A- 0 905 436
- EP-A- 0 905 524
- FR-A- 2 743 871
- GB-A- 2 180 632
- US-A- 5 412 952
- US-A- 5 583 472
- US-A- 5 904 046
- PATENT ABSTRACTS OF JAPAN vol. 2000, no. 04, 31 August 2000 (2000-08-31) & JP 2000 018744 A (KANAZAWA INSTITUTE OF TECHNOLOGY), 18 January 2000 (2000-01-18)

## Description

### Field of the invention

The present invention relates to pulse tube refrigerators for recondensing cryogenic liquids. In particular, the present invention relates to the same for magnetic resonance imaging systems.

### Background to the Invention

In many cryogenic applications components, e.g. superconducting coils for magnetic resonance imaging (MRI), superconducting transformers, generators, electronics, are cooled by keeping them in contact with a volume of liquefied gases (e.g. Helium, Neon, Nitrogen, Argon, Methane). Any dissipation in the components or heat getting into the system causes the volume to part boil off. To account for the losses, replenishment is required. This service operation is considered to be problematic by many users and great efforts have been made over the years to introduce refrigerators that recondense any lost liquid right back into the bath.

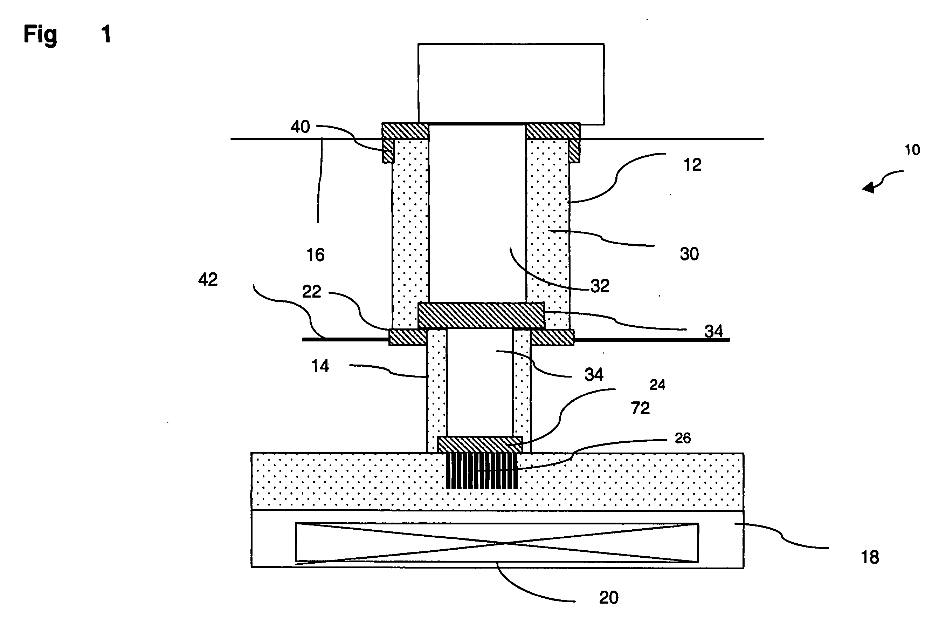

As an example of prior art, an embodiment of a two stage Gifford McMahon (GM) coldhead recondenser of an MRI magnet is shown in Figure 1. In order for the GM coldhead, indicated generally by 10, to be removable for service or repair, it is inserted into a sock, which connects the outside face of a vacuum vessel 16 (at room temperature) to a helium bath 18 at 4K. MRI magnets are indicated at 20. The sock is made of thin walled stainless steel tubes forming a first stage sleeve 12, and a second stage sleeve 14 in order to minimise heat conduction from room temperature to the cold end of the sock operating at cryogenic temperatures. The sock is filled with helium gas 30, which is at about 4.2K at the cold end and at room temperature at the warm end. The first stage sleeve 12 of the coldhead is connected to an intermediate heat station of the sock 22, in order to extract heat at an intermediate temperature, e.g. 40K-80K, and to which sleeve 14 is also connected. The second stage of the coldhead 24 is connected to a helium gas recondenser 26. Heat arises from conduction of heat down through the neck, heat radiated from a thermal radiation shield 42 as well as any other sources of heat for example, from a mechanical suspension system for the magnet, (not shown) and from a service neck (also not shown) used for filling the bath with liquids, instrumentation wiring access, gas escape route etc. A radiation shield 42 is placed intermediate the helium bath and the wall of the outer vacuum vessel.

The second stage of the coldhead is acting as a recondensor at about 4.2K. As it is slightly colder than the surrounding He gas, gas is condensed on the surface (which can be equipped with fins to increase surface area) and is dripped back into the liquid reservoir. Condensation locally reduces pressure, which pulls more gas towards the second stage. It has been calculated that there are hardly any losses due to natural convection of Helium, which has been verified experimentally provided that the coldhead and the sock are vertically oriented (defined as the warm end pointing upwards). Any small differences in the temperature profiles of the Gifford McMahon cooler and the walls would set up gravity assisted gas convection, as the density change of gas with temperature is great (e.g. at 4.2. K the density is 16kg/m³; at 300 K the density is 0.16kg/m³). Convection tends to equilibrate the temperature profiles of the sock wall and the refrigerator. The residual heat losses are small. Figure 1A shows a corresponding view without coldhead 32, 34 in place. In greater detail, the intermediate section 22 shows a passage 38 to enable helium gas to flow from the volume encircled by sleeve 14. The latter volume is also in fluid connection with the main bath 36 in which the magnet 20 is placed. Also shown is a flange 40 associated with sleeve 12 to assist in attaching the sock to the vacuum vessel 16.

When the arrangement is tilted, natural convection sets up huge losses. A solution to this problem has been described in US Patent, US-A-5,583,472, to Mitsubishi. Nevertheless, this will not be further discussed here, as this document relates to arrangements which are vertically oriented or at small angles (<30°) to the vertical.

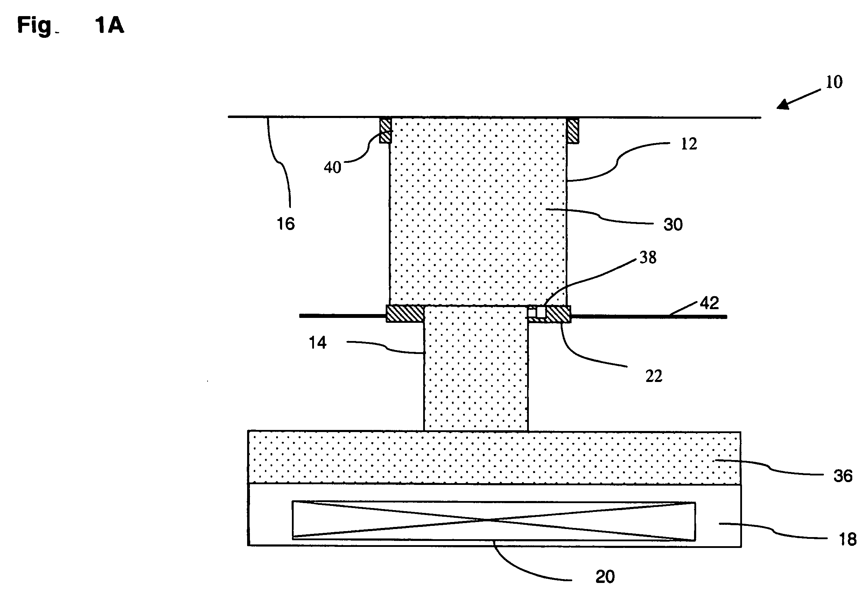

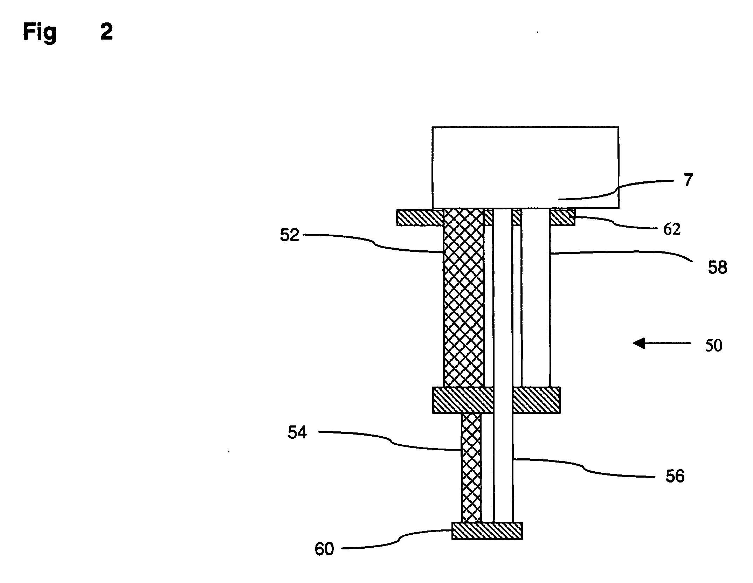

It has been shown that Pulse Tube Refrigerators (PTRs) can achieve useful cooling at temperatures of 4.2K (the boiling point of liquid helium at normal pressure) and below (C. Wang and P.E. Gifford, Advances in Cryogenic Engineering, 45, Edited by Shu et a., Kluwer Academic/Plenum Publishers,2000, pp.1-7). Pulse tube refrigerators are attractive, because they avoid any moving parts in the cold part of the refrigerator, thus reducing vibrations and wear of the refrigerator. Referring now to Figure 2, there is shown a PTR 50 comprising an arrangement of separate tubes, which are joined together at heat stations. There is one regenerator tube 52, 54 per stage, which is filled with solid materials in different forms (e.g. meshes, packed spheres, powders), that act as heat buffer and exchange heat with the working fluid of the PTR (usually He gas at a pressure of 1.5-2.5 MPa). There is one pulse tube 56, 58 per stage, which is hollow and used for expansion and compression of the working fluid. In two stage PTRs, the second stage pulse tube 56 usually links the second stage 60 with the warm end 62 at room temperature, the first stage pulse tube 58 linking the first stage 64 with the warm end.

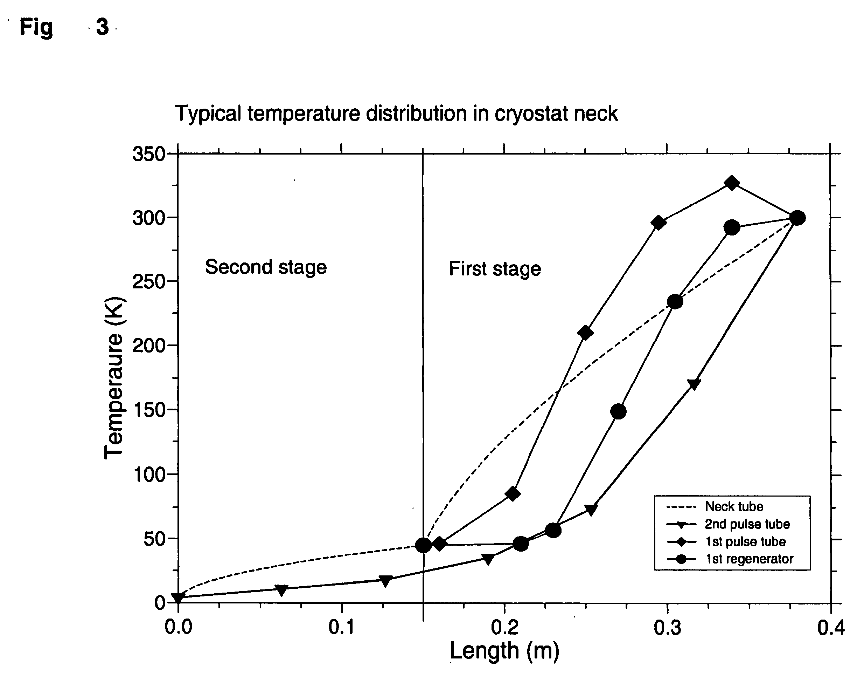

It has been found, that PTRs operating in vacuum under optimum conditions usually develop temperature profiles that are significantly different across the tubes and also from what would be a steady state temperature profile in a sock. This is shown in Figure 3.

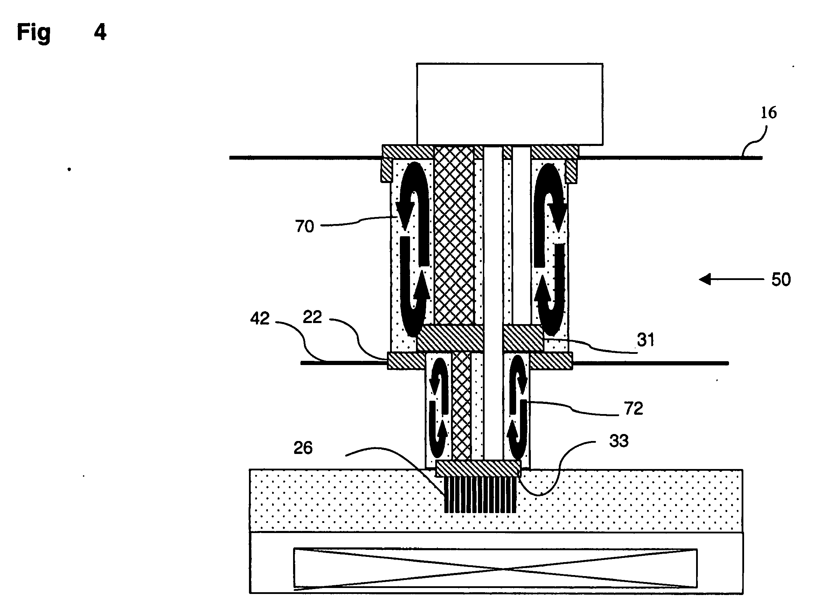

Another prior art pulse tube refrigerator arrangement is shown in Figure 4 wherein a pulse tube is inserted into a sock, and is exposed to a helium atmosphere wherein gravity induced convection currents 70, 72 are set up in the first and second stages. The PTR unit 50 is provided with cold stages 31, 33 which are set in a recess in an outer vacuum container 16. A radiation shield 42 is provided which is in thermal contact with first sleeve end 22. A recondenser 26 is shown on the end wall of second stage 33. If at a given height the temperatures of the different components are not equal, the warmer components will heat the surrounding helium, giving it buoyancy to rise, while at the colder components the gas is cooled and drops down. The resulting thermal losses are huge, as the density difference of helium gas at 1 bar changes by a factor of about 100 between 4.2 K and 300 K. The net cooling power of a PTR might be e.g. 40 W at 50 K, and 0.5W to 1 W at 4.2K. The losses have been calculated to be of the order of 5-20W. The internal working process of a pulse tube will, in general, be affected although this is not encountered in GM refrigerators. In a PTR, the optimum temperature profile in the tubes, which is a basis for optimum performance, arises through a delicate process balancing the influences of many parameters, e.g. geometries of all tubes, flow resistivities, velocities, heat transfer coefficients, valve settings etc. (A description can be found in Ray Radebaugh, proceedings of the 6th International Cryogenic Engineering Conference, Kitakkyushu, Japan, 20-24 May, 1996, pp22-44).

Therefore, in a helium environment, PTRs do not necessarily reach temperatures of 4 K, although they are capable of doing so in vacuum. Nevertheless, if the PTR is inserted in a vacuum sock with a heat contact to 4K through a solid wall, it would work normally. Such a solution has been described for a GM refrigerator (US Patent US-A-5,613,367 to William E. Chen, GE) although the use of a PTR would be possible and be straightforward. The disadvantage,however,is that the thermal contact of the coldhead at 4K would produce a thermal impedance, which effectively reduces the available power for refrigeration. As an example, with a state of the art thermal joint made from an Indium washer, a thermal contact resistance of 0.5 K/W can be achieved at 4 K (see e.g. US-A-5,918,470 to GE). If a cryocooler can absorb 1W at 4.2K (e.g. the model RDK 408 by Sumitomo Heavy Industries) then the temperature of the recondensor would rise to 4.7K, which would reduce the current carrying capability of the superconducting wire drastically. Alternatively, a stronger cryocooler would be required to produce 1 W at 3.7 K initially to make the cooling power available on the far side of the joint.

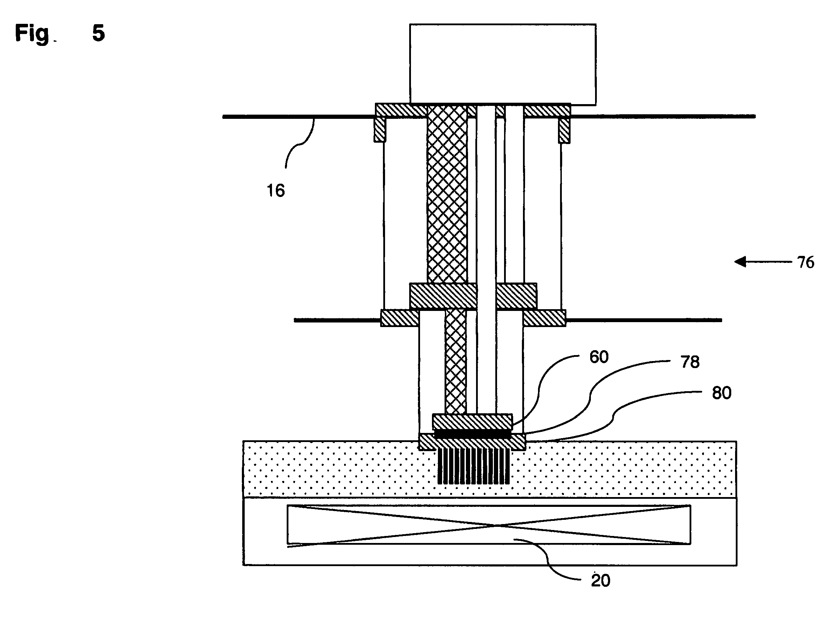

Figure 5 shows an example of such a PTR arrangement 76. The component features are substantially the same as shown in Figure 4. Thermal washer 78 is provided between the second stage of the PTR coldhead and a finned heat sink 80. A helium-tight wall is provided between the thermal washer and the heat sink.

Document EP-A-0 905 524 discloses a pulse tube refrigerator within a neck tube of a cryostat.

### Object of the invention

The present invention seeks to provide an improved pulse tube refrigerator.

### Statement of the Invention

In accordance with a first aspect of the invention, there is provided cryogenic cooling arrangements as defined in the appended claims.

Thus, the present invention enables problems associated with convection in a PTR to be substantially reduced or overcome without compromising heat transfer at the second stage by the introduction of a thermal contact or similar which are known to impede heat transfer characteristics.

### Brief description of the figures

The invention may be understood more readily, and various other aspects and features of the invention may become apparent, from consideration of the following description and the figures as shown in the accompanying drawing sheets, wherein:
Figure 1 shows a two stage Gifford McMahon coldhead recondenser in a MRI magnet;
Figure 1A shows the recondenser of Figure 1 without the recondenser tubes;
Figure 2 shows a dual stage PTR;
Figure 3 shows a temperature profile of elements within a sock;
Figure 4 shows a pulse tube inserted into a sock;
Figure 5 shows a prior art example of a pulse tube with a removable thermal contact;
Figure 6 shows a PTR in accordance with the present invention;

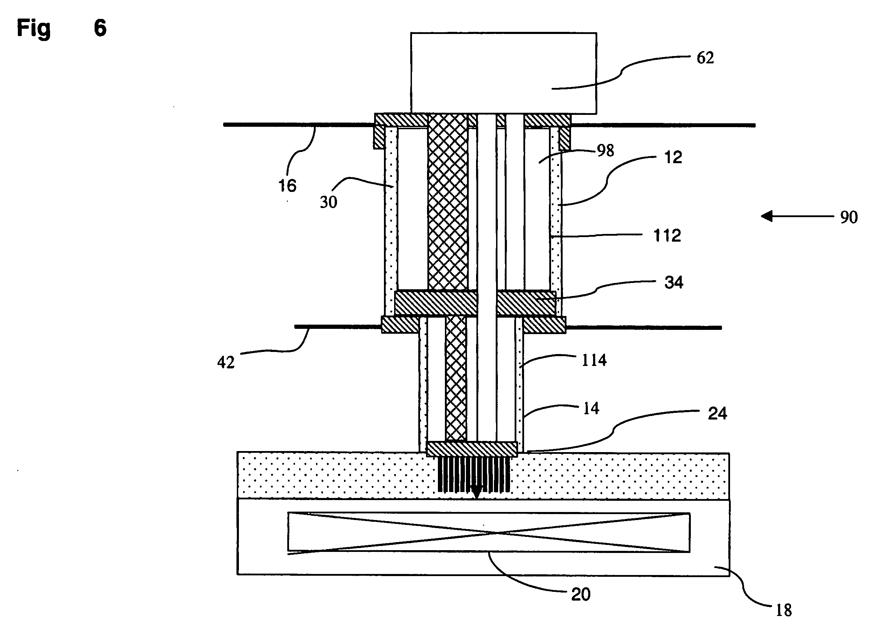

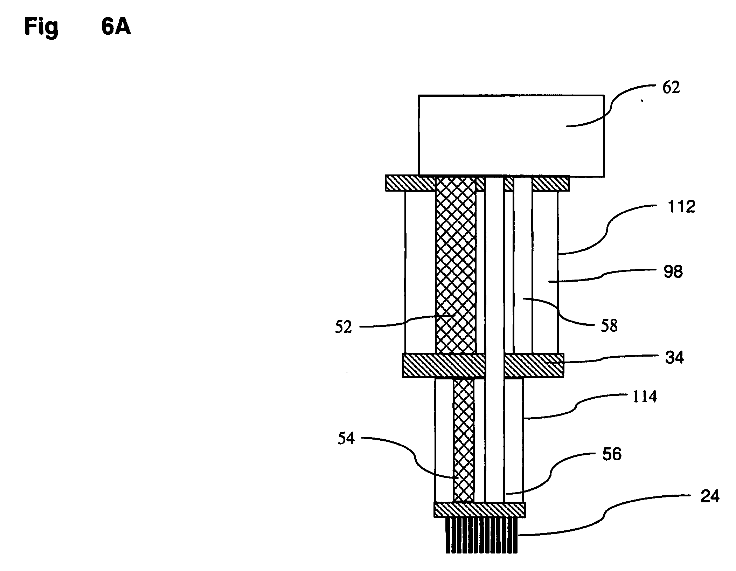

Figure 6Ashows the PTR of Figure 6 without the outer sock;

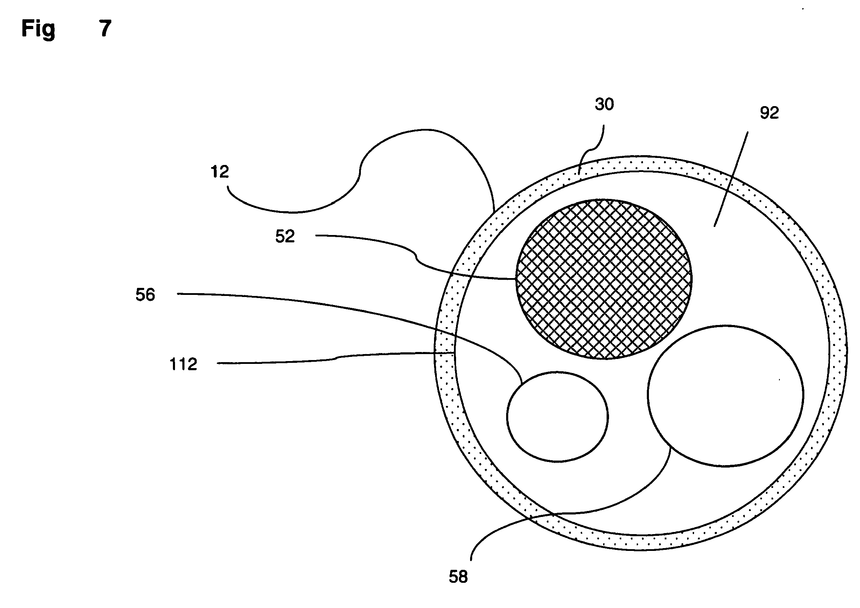

Figure 7 shows a horizontal section through the middle of the first stage of the arrangement shown in Figure 6;

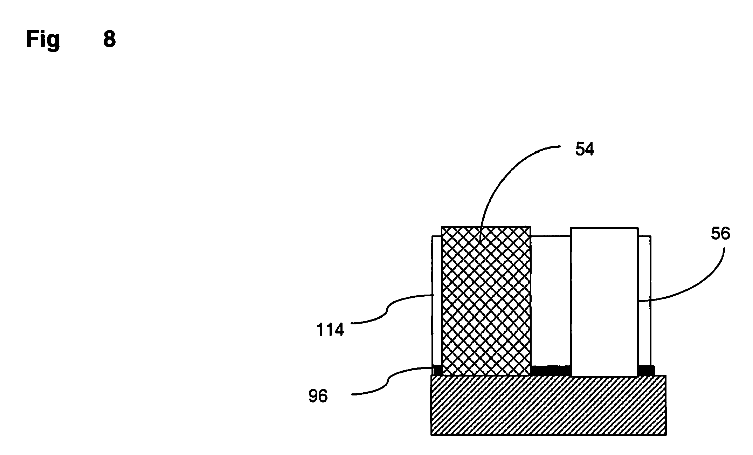

Figure 8 shows a tube wall;

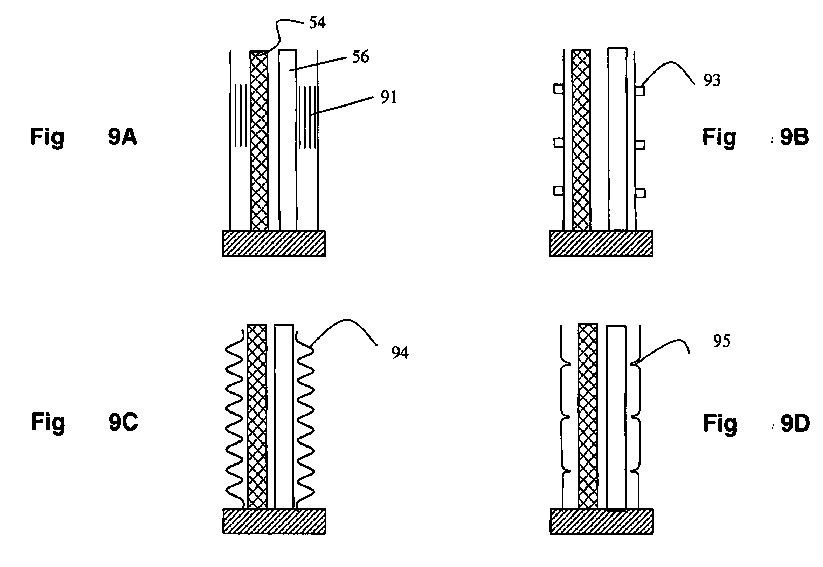

Figures 9 A,B,C and D, show different mechanical forms of the vacuum sleeve;

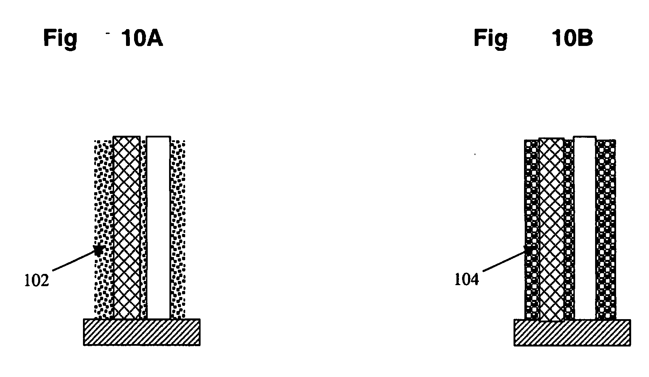

Fig 10A shows pulse tubes and regenerator tubes enclosed in an integrated sleeve of insulation material; and
Fig 10B shows a non-vacuum sleeve or low vacuum sleeve filled with loose insulation material.

### Detailed description of the invention

There will now be described, by way of example, the best mode contemplated by the inventors for carrying out the invention. In the following description, numerous specific details are set out in order to provide a complete understanding of the present invention. It will be apparent, however, to those skilled in the art, that the present invention may be put into practice with variations from the specific details.

Referring now to Figure 6, there is shown a first embodiment of the invention: there is provided a PTR 90 having individual tubes of the PTR being insulated by a dual sleeve assembly 12, 112; 14, 114 around the PTR tubes between the warm end of the PTR coldhead 62 and the first stage 34 and between the first stage 34 and the second stage 24.

The second stage sleeve can be of a reduced diameter with respect to the first stage sleeve. The sleeve walls 12, 14, 112, 114 can be double walled and may be evacuated during manufacture by joining them in a vacuum process, e.g. vacuum brazing or electron beam welding. In such cases, no separate evacuation process is required, no ports are fitted and a minimum complexity of parts is achieved. Alternatively, in another form, pump-out can be achieved after manufacture by fitting a separate evacuation port (not shown). The sleeve surrounds all the tubes of the arrangement, leaving only a small annular gap therebetween. The outer wall of the vacuum vessel of the magnet apparatus is shown by reference numeral 16; the magnet is indicated by reference numeral 20 in a helium bath having a wall 74. A radiation shield 42 is attached by way of a thermal contact 22 to the first stage 34. As mentioned earlier, there is a finned helium recondenser 76. Figure 6A shows the arrangement of Figure 6 without the outer sock and components outside the outer sock.

Figure 7 shows a horizontal cut through the middle of the arrangement between the coldhead also known as the warm end, and the first stage. The pulse and regeneration tubes are indicated by reference numeral 52, 56, 58. The walls of the sleeves can be fabricated from thin gauge stainless tube (or other suitable materials like Titanium, composites like GRP, CFRP, possibly with metallic liners to make them diffusion proof against helium leakage). The volume 98 within inner sock 112 is evacuated thus avoiding any heat convection losses. The tube is joined by conventional joining techniques like welding or brazing 84 to flanges associated with the coldhead and first and second stages. Figure 8 shows a section through the lower end of the second stage pulse and regeneration tubes 54, 56. A weld or brazed vacuum tight join is indicated at 96

The quality of the vacuum inside the sleeves 112, 114 can be enhanced by inserting getter materials, preferably at the cold end (e.g. activated charcoal, carbon paper etc, which can be wound around the tubes, zeolithes etc.). The insulation quality can be enhanced by placing Superinsulation^{™} foil 91 into the vacuum space, as shown in Figure 9A.

The insulating space between the tubes is not evacuated in manufacture and air will be present. During cool down, the air will condense and eventually freeze towards the cold end of the coldhead (4.2 K). Getter materials can be placed within this environment and are particularly helpful to reduce the pressure of the atmosphere within the insulating space. Whilst the quality of the insulation is compromised to a certain extent, this is offset by the fact that no vacuum lines or vacuum processes are required reducing manufacturing costs.

In Figures 9 B, C and D, different mechanical forms of the vacuum sleeve are demonstrated. For improved clarity, the figures show only the sleeve between the first and second stages. The wall thickness of the sleeve should be kept to a minimum, in order to reduce heat conduction. In order to avoid buckling under outside helium pressure (lbar-3 bar typically during operational modes), it can be reinforced in several ways, typically by corrugation of the walls 93, 94 as shown in Figures 9B and C, although further strengthening means 95 may be provided as in Figure 9D.

Although not giving the same amount of insulation, non-vacuum insulation can be applied between the tubes in the same geometry as the vacuum sleeve. The placement of such fillings can provide a greater resistance to buckling. As illustrated in Figure 10A pulse tubes and regenerator tubes can be enclosed by insulation material. Such as plastics foam 102, e.g. "Cryofoam" from Cryo-lite company, polyurethane foams, glass-fibre insulation, felts etc. Some foams can be expanded around the tube structure in situ. Figure 10B shows a non vacuum sleeve or low vacuum sleeve is filled with loose insulation materials, e.g. powder insulation like perlite or hollow glass spheres 104, which can be internally evacuated or even covered with a reflective film, for example, of sputtered aluminium, to reduce radiation.

The insulation for individual tube can differ among each other, any combination of insulation and partial insulation can be applied. For example, the first stage can be covered with a vacuum insulation, the second with free-standing foam insulation. Also, in some applications it can be sufficient to insulate just the first stage or the second stage only.

While most applications at 4K operate with two stage coolers, the same technology can also be applied to single stage coolers or three and more stage coolers.

## Claims

1. A cryogenic cooling arrangement comprising a helium bath (74) within a vacuum vessel (16) itself comprising an insertion sock (12, 14) filled with helium gas (30) and having an axis arranged within 30° of the vertical, to provide an access port between the vacuum vessel and the helium bath, said access port housing a pulse tube refrigerator (90) having a longitudinal axis aligned with the axis of the insertion sock and arranged within 30° of the vertical, and said pulse tube refrigerator comprising a first end (62) exposed to room temperature and a second end (60) associated with a cryogenic fluid, with at least one pulse tube (56) and at least one regenerator tube (52, 54) extending between the first end and the second end, the pulse tube refrigerator further comprising an insulating sleeve having a sleeve wall (112, 114) surrounding the at least one pulse tube and the at least one regenerator tube between the first end and the second end, said insulating sleeve further comprising a sealed evacuated region (98) between said sleeve wall and the corresponding pulse tube(s) and regenerator tube(s) for providing thermal insulation of the corresponding pulse tube(s) and regenerator tube(s).

2. A cryogenic cooling arrangement according to claim 1, further comprising an intermediate stage (34) between the first end and the second end, and further comprising at least one further pulse tube (58) extending between the first end and the intermediate stage, and wherein the at least one regenerator tube is thermally linked to the intermediate stage, wherein a first insulating sleeve having a first sleeve wall (112) is provided, surrounding the at least one pulse tube, the at least one further pulse tube and the at least one regenerator tube between the first end and the intermediate stage, said first insulating sleeve further comprising a first sealed evacuated region between said first sleeve wall and the corresponding pulse tube(s) and regenerator tube(s); and a second insulating sleeve having a second sleeve wall (114) is provided, surrounding the at least one pulse tube and the at least one regenerator tube between the intermediate stage and the second end, said second insulating sleeve further comprising a second sealed evacuated region between said second sleeve wall and the corresponding pulse tube(s) and regenerator tube(s).

3. A cryogenic cooling arrangement according to any preceding claim wherein a getter material is located within the, or one of the, evacuated region(s).

4. A cryogenic cooling arrangement according to any preceding claim, wherein Superinsulation^{™} foil is located within the, or one of the, evacuated region(s).

5. A cryogenic cooling arrangement according to any preceding claim wherein, in use, the, or one of the, evacuated region(s) contains frozen air.

6. A cryogenic cooling arrangement according to any preceding claim wherein the or each sleeve wall surrounds all of the corresponding tubes, leaving only a small annular gap between the tubes and the respective sleeve wall.

7. A cryogenic cooling arrangement comprising a helium bath (74) within a vacuum vessel (16) itself comprising an insertion sock (12, 14) filled with helium gas (30) and having an axis arranged within 30° of the vertical, to provide an access port between the vacuum vessel and the helium bath, said access port housing a pulse tube refrigerator (90) having a longitudinal axis aligned with the axis of the insertion sock and arranged within 30° of the vertical, and said pulse tube refrigerator comprising a first end (62) exposed to room temperature and a second end (60) associated with a cryogenic fluid, with at least one pulse tube (56) and at least one regenerator tube (52, 54) extending between the first end and the second end, the pulse tube refrigerator further comprising an insulating sleeve having a sleeve wall surrounding the at least one pulse tube and the at least one regenerator tube between the first end and the second end, said insulating sleeve further comprising a sealed region between said sleeve wall and the corresponding pulse tube(s) and regenerator tube(s), said sealed region containing loose insulation material (104) in contact with the sleeve wall and the corresponding pulse tube(s) and regenerator tube(s) for providing thermal insulation of the corresponding pulse tube(s) and regenerator tube(s).

8. A cryogenic cooling arrangement according to claim 7, further comprising an intermediate stage (34) between the first end and the second end, and further comprising at least one further pulse tube (58) extending between the first end and the intermediate stage, and wherein the at least one regenerator tube is thermally linked to the intermediate stage, wherein a first insulating sleeve having a first sleeve wall (112) is provided, surrounding the at least one pulse tube, the at least one further pulse tube and the at least one regenerator tube between the first end and the intermediate stage, said first insulating sleeve further comprising a first sealed region containing loose insulation material between said first sleeve wall and the corresponding pulse tube(s) and regenerator tube(s); and a second insulating sleeve having a second sleeve wall (114) is provided, surrounding the at least one pulse tube and the at least one regenerator tube between the intermediate stage and the second end, said second insulating sleeve further comprising a second sealed region containing loose insulation material between said second sleeve wall and the corresponding pulse tube(s) and regenerator tube(s).

9. A cryogenic cooling arrangement according to claim 7 or claim 8 wherein the loose insulation material is chosen from among the group consisting of: perlite powder, hollow glass spheres, evacuated hollow glass spheres, hollow glass spheres covered with a reflective film.

10. A cryogenic cooling arrangement according to any preceding claim wherein the, or at least one of the, sleeve wall(s) is corrugated.

11. A cryogenic cooling arrangement according to any preceding claim wherein the, or at least one of the, sleeve wall(s) is provided with further strengthening means.

12. A cryogenic cooling arrangement according to any preceding claim wherein the, or at least one of the, sleeve wall(s) is fabricated from stainless steel, titanium or composite materials such as glass reinforced plastic (GRP) or carbon fibre reinforced plastic (CFRP).

13. A cryogenic cooling arrangement according to claim 12 wherein the, or at least one of the, sleeve wall(s) is fabricated from composite materials such as glass reinforced plastic (GRP) or carbon fibre reinforced plastic (CFRP) and is lined with a metallic liner.

14. A cryogenic cooling arrangement comprising a helium bath (74) within a vacuum vessel (16) itself comprising an insertion sock (12, 14) filled with helium gas (30) and having an axis arranged within 30° of the vertical, to provide an access port between the vacuum vessel and the helium bath, said access port housing a pulse tube refrigerator (90) having a longitudinal axis aligned with the axis of the insertion sock and arranged within 30° of the vertical, and said pulse tube refrigerator comprising a first end (62) exposed to room temperature and a second end (60) associated with a cryogenic fluid, with at least one pulse tube (56) and at least one regenerator tube (52, 54) extending between the first end and the second end, the pulse tube refrigerator further comprising an insulating sleeve consisting of a free-standing foam insulation (102) enclosing the at least one pulse tube and the at least one regenerator tube between the first end and the second end, said insulation sleeve being in contact with the corresponding pulse tube(s) and regenerator tube(s) for providing thermal insulation of the corresponding pulse tube(s) and regenerator tube(s).

15. A cryogenic cooling arrangement according to claim 14, further comprising an intermediate stage (34) between the first end and the second end, and further comprising at least one further pulse tube (58) extending between the first end and the intermediate stage, and wherein the at least one regenerator tube is thermally linked to the intermediate stage, wherein a first insulation sleeve is provided, consisting of a free-standing foam insulation, surrounding the at least one pulse tube, the at least one further pulse tube and the at least one regenerator tube between the first end and the intermediate stage; and a second insulation sleeve is provided, consisting of a free-standing foam insulation, surrounding the at least one pulse tube and the at least one regenerator tube between the intermediate stage and the second end.

16. A cryogenic cooling arrangement according to claim 14 or claim 15 wherein the free-standing foam insulation is chosen from among the group consisting of: plastics foam, polyurethane foams.

## Patentansprüche

1. Kryogene Kühlanordnung, welche ein Heliumbad (74) mit einem Vakuumgefäß (16) umfasst, das seinerseits eine Einfügungs-Ummantelung (12, 14) umfasst, die mit Heliumgas (30) gefüllt ist und eine Achse aufweist, die mit der Vertikalen einen Winkel von maximal 30° bildet, um einen Zugangskanal zwischen dem Vakuumgefäß und dem Heliumbad bereitzustellen, wobei der besagte Zugangskanal einen Pulsrohrkühler (90) beherbergt, der eine Längsachse aufweist, die mit der Achse der Einfügungs-Ummantelung fluchtet und mit der Vertikalen einen Winkel von maximal 30° bildet, und wobei der besagte Pulsrohrkühler ein erstes Ende (62), welches Raumtemperatur ausgesetzt ist, und ein zweites Ende (60), das mit einem kryogenen Fluid verbunden ist, umfasst, wobei sich mindestens ein Pulsrohr (56) und mindestens ein Regeneratorrohr (52, 54) zwischen dem ersten Ende und dem zweiten Ende erstrecken, wobei der Pulsrohrkühler ferner eine Isolierhülle umfasst, die eine Hüllenwand (112, 114) aufweist, die das mindestens eine Pulsrohr und das mindestens eine Regeneratorrohr zwischen dem ersten Ende und dem zweiten Ende umgibt, wobei die besagte Isolierhülle ferner einen abgedichteten evakuierten Bereich (98) zwischen der besagten Hüllenwand und dem (den) entsprechenden Pulsrohr(en) und Regeneratorrohr(en) umfasst, um eine Wärmeisolation der (des) entsprechenden Pulsrohre(s) und Regeneratorrohre(s) zu gewährleisten.

2. Kryogene Kühlanordnung nach Anspruch 1, welche ferner eine Zwischenstufe (34) zwischen dem ersten Ende und dem zweiten Ende umfasst und ferner mindestens ein weiteres Pulsrohr (58) umfasst, das sich zwischen dem ersten Ende und der Zwischenstufe erstreckt, und wobei das mindestens eine Regeneratorrohr mit der Zwischenstufe thermisch gekoppelt ist, wobei eine erste Isolierhülle mit einer ersten Hüllenwand (112) vorgesehen ist, die das mindestens eine Pulsrohr, das mindestens eine weitere Pulsrohr und das mindestens eine Regeneratorrohr zwischen dem ersten Ende und der Zwischenstufe umgibt, wobei die besagte erste Isolierhülle ferner einen ersten abgedichteten evakuierten Bereich zwischen der besagten ersten Hüllenwand und dem (den) entsprechenden Pulsrohr(en) und Regeneratorrohr(en) umfasst; und wobei eine zweite Isolierhülle mit einer zweiten Hüllenwand (114) vorgesehen ist, die das mindestens eine Pulsrohr und das mindestens eine Regeneratorrohr zwischen der Zwischenstufe und dem zweiten Ende umgibt, wobei die besagte zweite Isolierhülle ferner einen zweiten abgedichteten evakuierten Bereich zwischen der besagten zweiten Hüllenwand und dem (den) entsprechenden Pulsrohr(en) und Regeneratorrohr(en) umfasst.

3. Kryogene Kühlanordnung nach einem der vorhergehenden Ansprüche, wobei sich ein Gettermaterial innerhalb der oder innerhalb eines der evakuierten Bereiche befindet.

4. Kryogene Kühlanordnung nach einem der vorhergehenden Ansprüche, wobei sich Superinsulation^{™} Folie innerhalb der oder innerhalb eines der evakuierten Bereiche befindet.

5. Kryogene Kühlanordnung nach einem der vorhergehenden Ansprüche, wobei, in Betrieb, die oder einer der evakuierten Bereiche gefrorene Luft enthalten (enthält).

6. Kryogene Kühlanordnung nach einem der vorhergehenden Ansprüche, wobei die oder jede Hüllenwand sämtliche entsprechenden Rohre umgibt, so dass nur ein schmaler ringförmiger Zwischenraum zwischen den Rohren und der entsprechenden Hüllenwand verbleibt.

7. Kryogene Kühlanordnung, welche ein Heliumbad (74) mit einem Vakuumgefäß (16) umfasst, das seinerseits eine Einfügungs-Ummantelung (12, 14) umfasst, die mit Heliumgas (30) gefüllt ist und eine Achse aufweist, die mit der Vertikalen einen Winkel von maximal 30° bildet, um einen Zugangskanal zwischen dem Vakuumgefäß und dem Heliumbad bereitzustellen, wobei der besagte Zugangskanal einen Pulsrohrkühler (90) beherbergt, der eine Längsachse aufweist, die mit der Achse der Einfügungs-Ummantelung fluchtet und mit der Vertikalen einen Winkel von maximal 30° bildet, und wobei der besagte Pulsrohrkühler ein erstes Ende (62), welches Raumtemperatur ausgesetzt ist, und ein zweites Ende (60), das mit einem kryogenen Fluid verbunden ist, umfasst, wobei sich mindestens ein Pulsrohr (56) und mindestens ein Regeneratorrohr (52, 54) zwischen dem ersten Ende und dem zweiten Ende erstrecken, wobei der Pulsrohrkühler ferner eine Isolierhülle umfasst, die eine Hüllenwand aufweist, die das mindestens eine Pulsrohr und das mindestens eine Regeneratorrohr zwischen dem ersten Ende und dem zweiten Ende umgibt, wobei die besagte Isolierhülle ferner einen abgedichteten Bereich zwischen der besagten Hüllenwand und dem (den) entsprechenden Pulsrohr(en) und Regeneratorrohr(en) umfasst, wobei der besagte abgedichtete Bereich loses Isolationsmaterial (104) enthält, das sich mit der Hüllenwand und dem (den) entsprechenden Pulsrohr(en) und Regeneratorrohr(en) in Kontakt befindet, um eine Wärmeisolation der (des) entsprechenden Pulsrohre(s) und Regeneratorrohre(s) zu gewährleisten.

8. Kryogene Kühlanordnung nach Anspruch 7, welche ferner eine Zwischenstufe (34) zwischen dem ersten Ende und dem zweiten Ende umfasst und ferner mindestens ein weiteres Pulsrohr (58) umfasst, das sich zwischen dem ersten Ende und der Zwischenstufe erstreckt, und wobei das mindestens eine Regeneratorrohr mit der Zwischenstufe thermisch gekoppelt ist, wobei eine erste Isolierhülle mit einer ersten Hüllenwand (112) vorgesehen ist, die das mindestens eine Pulsrohr, das mindestens eine weitere Pulsrohr und das mindestens eine Regeneratorrohr zwischen dem ersten Ende und der Zwischenstufe umgibt, wobei die besagte erste Isolierhülle ferner einen ersten abgedichteten Bereich, der loses Isolationsmaterial enthält, zwischen der besagten ersten Hüllenwand und dem (den) entsprechenden Pulsrohr(en) und Regeneratorrohr(en) umfasst; und wobei eine zweite Isolierhülle mit einer zweiten Hüllenwand (114) vorgesehen ist, die das mindestens eine Pulsrohr und das mindestens eine Regeneratorrohr zwischen der Zwischenstufe und dem zweiten Ende umgibt, wobei die besagte zweite Isolierhülle ferner einen zweiten abgedichteten Bereich, der loses Isolationsmaterial enthält, zwischen der besagten zweiten Hüllenwand und dem (den) entsprechenden Pulsrohr(en) und Regeneratorrohr(en) umfasst.

9. Kryogene Kühlanordnung nach Anspruch 7 oder Anspruch 8, wobei das lose Isolationsmaterial aus der Gruppe gewählt ist, welche besteht aus: Perlitpulver, hohlen Glaskugeln, evakuierten hohlen Glaskugeln, mit einer Reflexionsschicht bedeckten hohlen Glaskugeln.

10. Kryogene Kühlanordnung nach einem der vorhergehenden Ansprüche, wobei die oder wenigstens einer der Hüllenwände gewellt sind (ist).

11. Kryogene Kühlanordnung nach einem der vorhergehenden Ansprüche, wobei die oder wenigstens einer der Hüllenwände mit weiteren Verstärkungsmitteln versehen sind (ist).

12. Kryogene Kühlanordnung nach einem der vorhergehenden Ansprüche, wobei die oder wenigstens einer der Hüllenwände aus nichtrostendem Stahl, Titan oder Verbundwerkstoffen wie etwa glasfaserverstärktem Kunststoff (GFK) oder kohlenstofffaserverstärktem Kunststoff (CFK) hergestellt sind (ist).

13. Kryogene Kühlanordnung nach Anspruch 12, wobei die oder wenigstens einer der Hüllenwände aus Verbundwerkstoffen wie etwa glasfaserverstärktem Kunststoff (GFK) oder kohlenstofffaserverstärktem Kunststoff (CFK) hergestellt sind (ist) und mit einer metallischen Auskleidung ausgekleidet sind (ist).

14. Kryogene Kühlanordnung, welche ein Heliumbad (74) mit einem Vakuumgefäß (16) umfasst, das seinerseits eine Einfügungs-Ummantelung (12, 14) umfasst, die mit Heliumgas (30) gefüllt ist und eine Achse aufweist, die mit der Vertikalen einen Winkel von maximal 30° bildet, um einen Zugangskanal zwischen dem Vakuumgefäß und dem Heliumbad bereitzustellen, wobei der besagte Zugangskanal einen Pulsrohrkühler (90) beherbergt, der eine Längsachse aufweist, die mit der Achse der Einfügungs-Ummantelung fluchtet und mit der Vertikalen einen Winkel von maximal 30° bildet, und wobei der besagte Pulsrohrkühler ein erstes Ende (62), welches Raumtemperatur ausgesetzt ist, und ein zweites Ende (60), das mit einem kryogenen Fluid verbunden ist, umfasst, wobei sich mindestens ein Pulsrohr (56) und mindestens ein Regeneratorrohr (52, 54) zwischen dem ersten Ende und dem zweiten Ende erstrecken, wobei der Pulsrohrkühler ferner eine Isolierhülle umfasst, die aus einer freistehenden Schaumstoffisolation (102) besteht, die das mindestens eine Pulsrohr und das mindestens eine Regeneratorrohr zwischen dem ersten Ende und dem zweiten Ende umschließt, wobei sich die besagte Isolationshülle in Kontakt mit dem (den) entsprechenden Pulsrohr(en) und Regeneratorrohr(en) befindet, um eine Wärmeisolation der (des) entsprechenden Pulsrohre(s) und Regeneratorrohre(s) zu gewährleisten.

15. Kryogene Kühlanordnung nach Anspruch 14, welche ferner eine Zwischenstufe (34) zwischen dem ersten Ende und dem zweiten Ende umfasst und ferner mindestens ein weiteres Pulsrohr (58) umfasst, das sich zwischen dem ersten Ende und der Zwischenstufe erstreckt, und wobei das mindestens eine Regeneratorrohr mit der Zwischenstufe thermisch gekoppelt ist, wobei eine erste Isolierhülle vorgesehen ist, die aus einer freistehenden Schaumstoffisolation besteht, die das mindestens eine Pulsrohr, das mindestens eine weitere Pulsrohr und das mindestens eine Regeneratorrohr zwischen dem ersten Ende und der Zwischenstufe umgibt; und wobei eine zweite Isolierhülle vorgesehen ist, die aus einer freistehenden Schaumstoffisolation besteht, die das mindestens eine Pulsrohr und das mindestens eine Regeneratorrohr zwischen der Zwischenstufe und dem zweiten Ende umgibt.

16. Kryogene Kühlanordnung nach Anspruch 14 oder 15, wobei die freistehende Schaumstoffisolation aus der Gruppe gewählt ist, welche besteht aus: Schaumkunststoffen, Polyurethanschaumstoffen.

## Revendications

1. Montage de refroidissement cryogénique comprenant un bain d'hélium (74) dans une enceinte à vide (16) comprenant elle-même un manchon d'insertion (12, 14) rempli d'hélium gazeux (30) et ayant un axe agencé sous un angle de 30° par rapport à la verticale, pour ménager un orifice d'accès entre l'enceinte à vide et le bain d'hélium, ledit orifice d'accès abritant un réfrigérateur à tube à gaz pulsé (90) ayant un axe longitudinal aligné sur l'axe du manchon d'insertion et agencé sous un angle de 30° par rapport à la verticale, et ledit réfrigérateur à tube à gaz pulsé, comprenant une première extrémité (62) exposée à la température ambiante et une seconde extrémité (60) associée à un fluide cryogénique, au moins un tube à gaz pulsé (56) et au moins un tube récupérateur (52, 54) s'étendant entre la première extrémité et la seconde extrémité, le réfrigérateur à tube à gaz pulsé comprenant par ailleurs une gaine isolante comportant une paroi de gaine (112, 114) entourant au moins un tube à gaz pulsé et au moins un tube récupérateur entre la première extrémité et la seconde extrémité, ladite gaine isolante comprenant par ailleurs une zone étanche sous vide (98) entre ladite paroi de gaine et le ou les tubes à gaz pulsé et le ou les tubes récupérateurs correspondants pour procurer une isolation thermique du ou des tubes à gaz pulsé, et du ou des tubes récupérateurs correspondants.

2. Montage de refroidissement cryogénique selon la revendication 1, comprenant par ailleurs un étage intermédiaire (34) entre la première extrémité et la seconde extrémité, et comprenant aussi au moins un tube à gaz pulsé supplémentaire (58) s'étendant entre la première extrémité et l'étage intermédiaire, et dans lequel au moins un tube récupérateur est relié thermiquement à l'étage intermédiaire, dans lequel une première gaine isolante comportant une première paroi de gaine (112) est prévue autour d'au moins un tube à gaz pulsé, d'au moins un tube à gaz pulsé supplémentaire et d'au moins un tube récupérateur entre la première extrémité et l'étage intermédiaire, ladite première gaine isolante comprenant par ailleurs une première zone étanche sous vide entre ladite première paroi de gaine et le ou les tubes à gaz pulsé et le ou les tubes récupérateurs correspondants, et une seconde gaine isolante comportant une seconde paroi de gaine (114) est prévue autour d'au moins un tube à gaz pulsé et d'au moins un tube récupérateur entre l'étage intermédiaire et la seconde extrémité, ladite seconde gaine isolante comprenant par ailleurs une seconde zone étanche sous vide entre ladite seconde paroi de gaine et le ou les tubes à gaz pulsé et le ou les tubes récupérateurs correspondants.

3. Montage de refroidissement cryogénique selon l'une quelconque des revendications précédentes, dans lequel un matériau dégazeur est situé à l'intérieur de la ou des zones sous vide ou de l'une d'elles.

4. Montage de refroidissement cryogénique selon l'une quelconque des revendications précédentes, dans lequel un film Superinsulation^{™} est situé à l'intérieur de la ou des zones sous vide ou de l'une d'elles.

5. Montage de refroidissement cryogénique selon l'une quelconque des revendications précédentes, dans lequel, en service, la ou les zones sous vide, ou l'une d'elles, contient de l'air gelé.

6. Montage de refroidissement cryogénique selon l'une quelconque des revendications précédentes dans lequel la ou chaque paroi de gaine entoure la totalité des tubes correspondants, ne laissent qu'un petit espace annulaire entre les tubes et la paroi de gaine respective.

7. Montage de refroidissement cryogénique comprenant un bain d'hélium (74) dans une enceinte à vide (16) comprenant elle-même un manchon d'insertion (12, 14) rempli d'hélium gazeux (30) et ayant un axe agencé sous un angle de 30° par rapport à la verticale pour ménager un orifice d'accès entre l'enceinte à vide et le bain d'hélium, ledit orifice d'accès abritant un réfrigérateur à tube à gaz pulsé (90) ayant un axe longitudinal aligné sur l'axe du manchon d'insertion et agencé sous un angle de 30° par rapport à la verticale, et ledit réfrigérateur à tube à gaz pulsé comprenant une première extrémité (62) exposée à la température ambiante et une seconde extrémité (60) associée à un fluide cryogénique, au moins un tube à gaz pulsé (56) et au moins un tube récupérateur (52, 54) s'étendant entre la première extrémité et la seconde extrémité, le réfrigérateur à tube à gaz pulsé comprenant par ailleurs une gaine isolante comportant une paroi de gaine entourant le au moins un tube à gaz pulsé et le au moins un tube récupérateur entre la première extrémité et la seconde extrémité, ladite gaine isolante comprenant par ailleurs une zone étanche entre ladite paroi de gaine et le ou les tubes à gaz pulsé et le ou les tubes récupérateurs correspondants, ladite zone étanche contenant un matériau isolant en vrac (104) en contact avec la paroi de gaine et le ou les tubes à gaz pulsé et le ou les tubes récupérateurs correspondants pour procurer une isolation thermique du ou des tubes à gaz pulsé et du ou des tubes récupérateurs correspondants.

8. Montage de refroidissement cryogénique selon la revendication 7, comprenant par ailleurs un étage intermédiaire (34) entre la première extrémité et la seconde extrémité, et comprenant par ailleurs au moins un tube à gaz pulsé supplémentaire (58) s'étendant entre la première extrémité et l'étage intermédiaire, et dans lequel au moins un tube récupérateur est relié thermiquement à l'étage intermédiaire, dans lequel une première gaine isolante comportant une première paroi de gaine (112) est prévue autour d'au moins un tube à gaz pulsé, d'au moins un tube à gaz pulsé supplémentaire et d'au moins un tube récupérateur entre la première extrémité et l'étage intermédiaire, ladite première gaine isolante comprenant par ailleurs une première zone étanche contenant du matériau isolant en vrac entre ladite première paroi de gaine et le ou les tubes à gaz pulsé et le ou les tubes récupérateurs correspondants, et une seconde gaine isolante comportant une seconde paroi de gaine (114) est prévue autour d'au moins un tube à gaz pulsé et d'au moins un tube récupérateur entre l'étage intermédiaire et la seconde extrémité, ladite seconde gaine isolante comprenant par ailleurs une seconde zone étanche contenant du matériau isolant en vrac entre ladite seconde paroi de gaine et le ou les tubes à gaz pulsé et le ou les tubes récupérateurs correspondants.

9. Montage de refroidissement cryogénique selon la revendication 7 ou la revendication 8 dans lequel le matériau isolant en vrac est choisi dans le groupe constitué : de la poudre de perlite, de sphères de verre creuses, de sphères de verre creuses dans lesquelles on a fait le vide, et de sphères de verre creuses couvertes d'un film réfléchissant.

10. Montage de refroidissement cryogénique selon l'une quelconque des revendications précédentes dans lequel la ou les parois de gaine, ou au moins l'une d'elles, est ondulée.

11. Montage de refroidissement cryogénique selon l'une quelconque des revendications précédentes dans lequel la ou les parois de gaine, ou au moins l'une d'elles, est pourvue de moyens de renforcement supplémentaires.

12. Montage de refroidissement cryogénique selon l'une quelconque des revendications précédentes dans lequel la ou les parois de gaine, ou au moins l'une d'elles, est fabriquée en acier inoxydable, en titane ou en des matériaux composites tels que le plastique armé à la fibre de verre (GRP) ou le plastique armé à la fibre de carbone (CFRP).

13. Montage de refroidissement cryogénique selon la revendication 12 dans lequel la ou les parois de gaine, ou au moins l'une d'elles, est fabriquée en des matériaux composites tels que le plastique armé à la fibre de verre (GRP) ou le plastique armé à la fibre de carbone (CFRP) et est garnie d'un revêtement métallique.

14. Montage de refroidissement cryogénique comprenant un bain d'hélium (74) dans une enceinte à vide (16) comprenant elle-même un manchon d'insertion (12, 14) rempli d'hélium gazeux (30) et ayant un axe agencé sous un angle de 30° par rapport à la verticale pour ménager un orifice d'accès entre l'enceinte à vide et le bain d'hélium, ledit orifice d'accès abritant un réfrigérateur à tube à gaz pulsé (90) ayant un axe longitudinal aligné sur l'axe du manchon d'insertion et agencé sous un angle de 30° par rapport à la verticale, et ledit réfrigérateur à tube à gaz pulsé comprenant une première extrémité (62) exposée à la température ambiante et une seconde extrémité (60) associée à un fluide cryogénique, au moins un tube à gaz pulsé (56) et au moins un tube récupérateur (52, 54) s'étendant entre la première extrémité et la seconde extrémité, le réfrigérateur à tube à gaz pulsé comprenant par ailleurs une gaine isolante consistant en une isolation de mousse autoporteuse (102) enveloppant le au moins un tube à gaz pulsé et le au moins un tube régénérateur entre la première extrémité et la seconde extrémité, ladite gaine isolante étant en contact avec le ou les tubes à gaz pulsé et le ou les tubes récupérateurs correspondants pour procurer une isolation thermique du ou des tubes à gaz pulsé et du ou des tubes récupérateurs correspondants.

15. Montage de refroidissement cryogénique selon la revendication 14, comprenant par ailleurs un étage intermédiaire (34) entre la première extrémité et la seconde extrémité, et comprenant par ailleurs au moins un tube à gaz pulsé supplémentaire (58) s'étendant entre la première extrémité et l'étage intermédiaire, et dans lequel au moins un tube récupérateur est relié thermiquement à l'étage intermédiaire, dans lequel une première gaine isolante est prévue, consistant en une isolation de mousse autoporteuse, entourant au moins un tube à gaz pulsé, au moins un tube à gaz pulsé supplémentaire et au moins un tube récupérateur entre la première extrémité et l'étage intermédiaire, et une seconde gaine isolante est prévue, consistant en une isolation de mousse autoporteuse, entourant au moins un tube à gaz pulsé et au moins un tube récupérateur entre l'étage intermédiaire et la seconde extrémité.

16. Montage de refroidissement cryogénique selon la revendication 14 ou la revendication 15 dans lequel l'isolation de mousse autoporteuse est choisie dans le groupe constitué: du plastique mousse et de polyuréthanes cellulaires.
